# EUROPÄISCHE PATENTSCHRIFT

(11) **EP 2 398 660 B1**
(45) Veröffentlichungstag und Bekanntmachung des Hinweises auf die Patenterteilung: **12.03.2014**
(21) Anmeldenummer: 09765041.0
(22) Anmeldetag: 04.12.2009
(51) Int. Cl.: B60W 10/26, B60W 20/00, H02N 2/18, B60G 17/015

(54) **VERFAHREN UND LADEVORRICHTUNG ZUM AUFLADEN EINER KRAFTFAHRZEUGBATTERIE**
METHOD AND CHARGING APPARATUS FOR CHARGING A MOTOR VEHICLE BATTERY
PROCÉDÉ ET DISPOSITIF DE CHARGE POUR CHARGER UNE BATTERIE DE VÉHICULE À MOTEUR

(30) Priorität: 23.02.2009 DE 102009010144
(43) Veröffentlichungstag der Anmeldung: 28.12.2011
(73) Patentinhaber: Li-Tec Battery GmbH, 01917 Kamenz (DE)
(72) Erfinder: LACHENMEIER, Walter, 53757 Sankt Augustin (DE); GUTSCH, Andreas, 59348 Luedinghausen (DE); SCHAEFER, Tim, 99768 Harztor (DE)
(74) Vertreter: Wallinger, Michael
(86) Internationale Anmeldenummer: PCT/EP2009/008686
(87) Internationale Veröffentlichungsnummer: WO 2010/094312

(56) Entgegenhaltungen:
- WO-A1-2006/047926
- WO-A2-02/091552
- WO-A2-2007/106057
- BE-A1- 881 528
- FR-A1- 2 619 765
- JP-A- 2005 162 082
- US-A1- 2006 125 325

## Beschreibung

Die Erfindung betrifft ein Verfahren zum Aufladen einer Kraftfahrzeugbatterie während des Betriebs des Kraftfahrzeugs, sowie eine Ladevorrichtung und ein Kraftfahrzeug umfassend eine solche Ladevorrichtung.

Der Betrieb eines Kraftfahrzeugs ist auf vielerlei Arten stets verlustbehaftet. Hierunter ist zu verstehen, dass eine für den Betrieb des Kraftfahrzeugs potentiell zur Verfügung stehende Energie, wie z.B. die elektrische Energie einer Batterie oder die latente Energie eines Kraftstoffs, nur bedingt für den Betrieb des Kraftfahrzeugs genutzt werden kann. Aus dem Stand der Technik sind zahlreiche Ansätze bekannt, um die Energieeffizienz beim Betrieb eines Kraftfahrzeugs zu verbessern, indem z.B. Maßnahmen zur Erhöhung des Wirkungsgrads bei der Energiewandlung ergriffen werden.

Die WO 2007/106057 A2 beschreibt ein System und ein Verfahren zur Erzeugung elektrischer Energie aus mechanischer Deformationsenergie einer Fahrzeug-Radaufhängung.

Die Aufgabe der Erfindung ist es, die Energieeffizienz beim Betrieb eines Kraftfahrzeugs weiterhin zu verbessern. Diese Aufgabe wird gelöst von einem Verfahren oder einer Vorrichtung gemäß einem der unabhängigen Patentansprüche. Vorteilhafte und bevorzugte Weiterbildungen sind Gegenstand der jeweils abhängigen Ansprüche.

Erfindungsgemäß wird ein Verfahren zum Aufladen bzw. elektrischen Beladen wenigstens einer Kraftfahrzeugbatterie während des Betriebs des Kraftfahrzeugs vorgeschlagen, bei dem der Ladestrom für die Kraftfahrzeugbatterie zumindest teilweise durch das Umwandeln einer mechanischen Leistung an der Fahrzeugfederung gewonnen wird.

Eine Kraftfahrzeugbatterie ist eine Komponente, die elektrische Energie speichert und diese, bspw. zum Starten eines Verbrennungsmotors und/oder zum Betrieb eines Elektromotors, wieder abgibt. Gemäß ihrer Funktion kann eine solche Batterie auch als Akkumulator bezeichnet werden. Kraftfahrzeugbatterien sind für verschiedene Anwendungszwecke und in unterschiedlichen Spezifikationen am Markt insbesondere als fertig hergerichtete Komponenten erhältlich. Erfindungsgemäß kann auch eine Vielzahl von Kraftfahrzeugbatterien vorgesehen sein, die gleichzeitig oder nach einer festgelegten Hierarchie elektrisch aufgeladen werden.

Die Fahrzeugfederung ist Teil des Fahrwerks eines Kraftfahrzeugs. Sie soll gewährleisten, dass die Räder des Kraftfahrzeugs etwaigen Fahrbahnunebenheiten folgen, während hingegen der Aufbau des Kraftfahrzeugs hiervon weitgehend unbeeinflusst bleibt. Die Fahrzeugfederung dient damit einerseits dem Fahrkomfort, andererseits aber auch der Fahrsicherheit, indem sie den Fahrbahnkontakt der Räder gewährleistet. Eine Fahrzeugfederung umfasst meist mehrere Feder-Dämpfer-Kombination, die auch als Stoßdämpfer bezeichnet werden, und welche die Räder des Kraftfahrzeugs vom Aufbau des Kraftfahrzeugs schwingungsmäßig entkoppeln.

Moderne Berechungsverfahren zeigen, dass die Verlustleistung an der Fahrzeugfederung für einen Mittelklasse-PKW, der mit 100 km/h auf einer im wesentlichen ebenen Betonfahrbahn fährt, insgesamt etwa 4 kW und mehr beträgt. Die Erfindung beruht auf der Idee, diese Verlustleistung durch das Umwandeln in eine elektrische Energie bzw. in eine elektrische Leistung zurückzugewinnen und für das Aufladen der Kraftfahrzeugbatterie zu nutzen. Dies wird durch das erfindungsgemäße Verfahren bewerkstelligt. Dadurch kann die Energieeffizienz beim Betrieb eines Kraftfahrzeugs verbessert werden, wodurch der Energieverbrauch des Kraftfahrzeugs und die damit einhergehende Umweltbelastung gesenkt wird. Die Erfindung eignet sich gleichermaßen für PKWs und LKWs. Zudem eignet sich die Erfindung auch zur Nachrüstung älterer Kraftfahrzeuge.

Gemäß einer bevorzugten Weiterbildung ist vorgesehen, dass die mechanische Leistung an der Fahrzeugfederung eine Federleistung an wenigstens einem Stoßdämpfer des Kraftfahrzeugs ist, die zumindest teilweise in eine elektrische Leistung umgewandelt und als Ladestrom für die Kraftfahrzeugbatterie genutzt wird.

Wie oben bereits erläutert ist ein Stoßdämpfer eine Feder-Dämpfer-Kombination. Die Feder soll Fahrbahnstöße auffangen und in Schwingungen umwandeln. Der Dämpfer soll diese Schwingungen in möglichst kurzer Zeit dämpfen. Gemäß dem Stand der Technik wird hierbei ein Teil der Federleistung (Produkt aus Kraft und Federweg) in Wärme umgewandelt, welche ungenutzt an die Umgebung abgegeben wird. Demgegenüber wird erfindungsgemäß vorgeschlagen, aus dieser Federleistung zumindest teilweise einen Ladestrom zu generieren und diesen zum Aufladen der Kraftfahrzeugbatterie zu nutzen. Demnach fungiert der Stoßdämpfer als Generator. Das Abgreifen der generierten elektrischen Leistung am Stoßdämpfer erhöht zudem dessen Dämpfungswirkung. Durch schaltungstechnische und/oder steuerungstechnische Maßnahmen kann ferner auch eine asymptotische Dämpfung des Stoßdämpfers begünstigt werden.

Gemäß einer bevorzugten Weiterbildung ist vorgesehen, dass das Umwandeln an einem Stoßdämpfer auf einem induktiven Prinzip und/oder auf einem Piezo-Prinzip basiert. Das induktive Prinzip lässt sich insbesondere durch eine Spulen-Magnet-Kombination umsetzen, bei der durch Relativbewegung von Spule und Magnet eine nutzbare elektrische Spannung induziert wird. Das Piezo-Prinzip lässt sich bspw. durch Verwendung von handelsüblichen Piezokomponenten umsetzen. Alternativ und/oder ergänzend ist auch ein elektrochemisches Wandlungsprinzip denkbar.

Gemäß einer bevorzugten Weiterbildung ist vorgesehen, dass das Umwandeln zumindest eines Teils der mechanischen Federleistung in eine elektrische Leistung sowohl bei einem positiven Federweg als auch bei einem negativen Federweg am Stoßdämpfer erfolgt. Ein positiver Federweg ist beim Einfedern eines Rads in Richtung des Aufbaus des Kraftfahrzeugs gegeben, ein negativer Federweg ist beim entgegengesetzten Ausfedern eines Rads gegeben. Insbesondere ist vorgesehen, dass das Umwandeln zumindest beim Einfedern erfolgt.

Erfindungsgemäß wird ferner eine Ladevorrichtung für wenigstens eine Kraftfahrzeugbatterie vorgeschlagen, wobei diese Ladevorrichtung wenigstens einen Wandler umfasst, der eine mechanische Leistung an der Fahrzeugfederung zumindest teilweise in eine elektrische Leistung umwandelt und diese als Ladestrom für die Kraftfahrzeugbatterie bereitstellt. Diese Ladevorrichtung ist insbesondere für den Betrieb mit dem erfindungsgemäßen Verfahren geeignet bzw. hergerichtet. An dieser Stelle wird auf die obigen Ausführungen zum erfindungsgemäßen Verfahren verwiesen, welche sinngemäß auch auf die erfindungsgemäße Ladevorrichtung zutreffen.

Gemäß einer bevorzugten Weiterbildung ist vorgesehen, dass der Wandler in einen Stoßdämpfer der Fahrzeugfederung integriert ist. Der Begriff "integriert" ist hierbei weit auszulegen und umfasst jegliche kraftgekoppelte Anordnung von Stoßdämpfer und Wandler.

Gemäß einer bevorzugten Weiterbildung ist vorgesehen, dass der Wandler aus einer Spulen-Magnet-Kombination gebildet ist. Ein Magnet ist insbesondere ein Permanentmagnet. Ein Magnet kann hingegen auch ein Elektromagnet sein. Dies wird nachfolgend im Zusammenhang mit den Figuren noch näher erläutert.

Gemäß einer bevorzugten Weiterbildung ist vorgesehen, dass ein Stoßdämpfer wenigstens einen Linearmotor umfasst, der als Generator betrieben werden kann. Ein Linearmotor im Sinne der Erfindung ist ein elektromechanischer Wandler, der eine elektrische Größe, wie insbesondere einen Strom, in eine mechanische geradlinige Bewegung (Translationsbewegung) umsetzen kann und/oder umgekehrt. Bevorzugt kann dieser Linearmotor auch als Stellmotor betrieben werden, wodurch das Dämpfungsverhalten des Stoßdämpfers und damit das Federverhalten der Fahrzeugfederung bspw. situationserforderlich angepasst werden kann.

Gemäß einer bevorzugten Weiterbildung ist vorgesehen, dass eine Steuereinheit zur Regelung des Ladestroms umfasst ist. Die Steuereinheit ermöglicht u.a. eine Gleichrichtung, eine Linearisierung und/oder eine Begrenzung des Ladestroms, sowie eine Überwachung des Ladevorgangs einer Kraftfahrzeugbatterie in Echtzeit. Die Steuereinheit ermöglicht bevorzugt auch eine Regelung des Dämpfungsverhaltens wenigstens eines Stoßdämpfers. Insbesondere umfasst der Stoßdämpfer hierzu einen als Stellmotor betreibbaren Linearmotor, wie zuvor erläutert, der von der Steuereinheit angesteuert wird.

Gemäß einer bevorzugten Weiterbildung ist vorgesehen, dass die aufzuladende Kraftfahrzeugbatterie eine Lithium-Ionen-Batterie ist. Die Kombination mit einer solchen Lithium-Ionen-Batterie hat sich als besonders vorteilhaft erwiesen, da eine solche dynamische Auflade- und Entladevorgänge ermöglicht.

Erfindungsgemäß wird ferner ein Kraftfahrzeug vorgeschlagen, umfassend eine erfindungsgemäße Ladevorrichtung.

Gemäß einer bevorzugten Weiterbildung ist vorgesehen, dass dieses Kraftfahrzeug einen Elektroantrieb oder einen Hybridantrieb umfasst, der zumindest teilweise von der aufzuladenden Kraftfahrzeugbatterie mit Energie versorgt wird.

Weitere Vorteile, Merkmale und Anwendungsmöglichkeiten der vorliegenden Erfindung ergeben sich aus der nachfolgenden beispielhaften Beschreibung in Zusammenhang mit den Figuren. Es zeigen:
- Fig. 1: ein erfindungsgemäßes Kraftfahrzeug in einer schematischen Ansicht, und
- Fig. 2: eine schematische Schnittansicht eines Stoßdämpfers des Kraftfahrzeugs der Fig. 1.

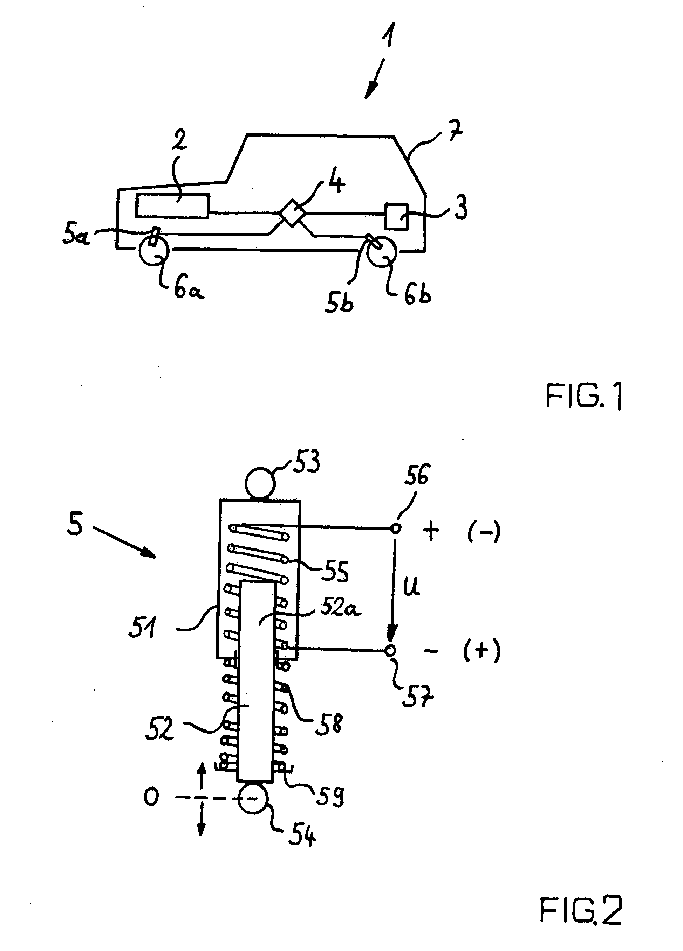

Fig.1 zeigt ein Kraftfahrzeug 1. Dieses umfasst einen Antriebsmotor 2, der als Verbrennungsmotor oder als Elektromotor ausgeführt sein kann. Anstelle des Antriebsmotors 2 kann auch ein Hybridantrieb vorgesehen sein. Das Kraftfahrzeug 2 umfasst weiterhin eine Kraftfahrzeugbatterie 3, die elektrische Energie speichert und diese wieder abgibt, bspw. zum Starten oder zum Betrieb des Antriebsmotors 2. Anstelle einer einzelnen Kraftfahrzeugbatterie 3 kann auch eine Vielzahl an Kraftfahrzeugbatterien umfasst sein. Die Kraftfahrzeugbatterie 3 ist bevorzugt als Lithium-Ionen-Batterie ausgeführt. Ferner ist eine Steuereinheit 4 umfasst, welche die Aufladung der Kraftfahrzeugbatterie und deren Entladung, d.h. die Leistungsabgabe, regelt. Die Räder 6a und 6b sind über Stoßdämpfer 5a und 5b einer Fahrzeugfederung mit dem Aufbau 7 des Kraftfahrzeugs verbunden.

Der Ladestrom zur Aufladung der Kraftfahrzeugbatterie 3 wird erfindungsgemäß zumindest teilweise durch das Umwandeln einer mechanischen Leistung an der Fahrzeugfederung gewonnen. Hierzu sind die Stoßdämpfer 5a und 5b mit einem Wandler ausgerüstet, der die mechanische Federleistung bzw. Federenergie zumindest teilweise in eine elektrische Leistung bzw. elektrische Energie umwandelt, die als Ladestrom zum Aufladen der Kraftfahrzeugbatterie 3 verwendet wird. Der Ladestrom und damit die Aufladung der Fahrzeugbatterie 3 wird von der Steuereinheit 4 geregelt.

Fig. 2 zeigt den Aufbau eines Stoßdämpfers 5 in einer schematischen Schnittansicht. Dieser umfasst ein Federbein 52 das teleskopartig in einer Aufnahme 51 gelagert ist. Koaxial zum Federbein 52 ist eine Schraubenfeder 58 angeordnet, welche sich gegen einen Federteller 59 und gegen die Aufnahme 51 abstützt. Die Feder 58 soll Fahrbahnstöße auffangen und in Schwingungen umwandeln, sowie den Fahrbahnkontakt des angebundenen Rads 6a bzw. 6b gewährleisten. Zur Verbindung mit dem Rad 6a bzw. 6b und mit dem Aufbau 7 weist der Stoßdämpfer 5 Befestigungseinrichtungen 53 und 54 auf, die hier beispielhaft als Ösen ausgebildet sind.

Das Federbein 52 weist bezüglich der Aufnahme 51 eine konstruktiv festgelegte Null-Lage 0 auf, die bspw. durch die Position der unteren Befestigungsvorrichtung 54 angegeben werden kann. Hierdurch ist auch die Null-Lage eines Rads 6a bzw. 6b zum Aufbau 7 definiert. Ausgehend von dieser Nulllage 0 kann das Federbein 52 einen positiven Federweg beschreiten, d.h. gemäß der Darstellung nach oben in die Aufnahme 51 einfedern, und einen negativen Federweg beschreiten, d.h. gemäß der Darstellung nach unten ausfedern.

Bei einer Bewegung des Federbeins 52 bewegt sich dessen in der Aufnahme 51 befindliches Ende 52a innerhalb einer in der Aufnahme 51 angeordneten elektrischen Spule 55. Die Spule 55 ist hier als einlagige Wicklung dargestellt, kann jedoch auch mehrlagig ausgebildet sein. Das Ende 52a des Federbeins 52 weist eine Permanentmagneteinrichtung auf, wodurch in der Spule 55 nach den physikalischen Induktionsgesetzen eine elektrische Spannung U induziert wird, die zwischen den Kontakten 56 und 57 abgreifbar ist. Das Vorzeichen der elektrischen Spannung U ist abhängig von der momentanen Bewegungsrichtung des Federbeins 52 relativ zur Aufnahme 51. Auf diese Weise kann unter Berücksichtigung eines Wirkungsgrads eine mechanische Federleistung in eine elektrische Leistung umgewandelt werden, die als Ladestrom für die Fahrzeugbatterie 3 genutzt wird.

Die zwischen den Anschlüssen 56 und 57 abgegriffene elektrische Leistung beeinflusst gleichzeitig das Dämpfungsverhalten des Stoßdämpfers 5, so dass über die elektrische Leistungsentnahme auch das Federverhalten der Fahrzeugfederung verändert bzw. eingestellt und damit situationserforderlich angepasst werden kann. Dies wird gleichfalls über die Steuereinrichtung 4 geregelt. Ergänzend kann der Stoßdämpfer 5 mit weiteren Dämpfungselementen versehen sein, wie z.B. einem Öldruck- oder Gasdruckdämpfer.

Anstelle einer Permanentmagneteinrichtung am Ende 52a des Federbeins 52 kann auch ein regelbarer Elektromagnet eingesetzt werden. Abweichend von der gezeigten Ausführungsform eines Stoßdämpfers 5 kann die Spule 55 auch am Ende 52a des Federbeins 52 und eine Permanentmagneteinrichtung und/oder Elektromagneteinrichtung an der Aufnahme 51 angeordnet werden.

Anstelle der gezeigten Spulen-Magnet-Kombination kann auch ein Linearmotor in den Stoßdämpfer 5 integriert werden, der wahlweise als Generator oder als Stellmotor betrieben werden kann. Hierdurch kann das Dämpfungsverhalten des Stoßdämpfers aktiv verändert werden, was situationserforderlich durch die Steuereinheit 4 geregelt wird.

Anstelle des gezeigten teleskopartigen Stoßdämpfers 5 mit der Schraubenfeder 58 können auch andere Stoßdämpfertypen eingesetzt werden, die z.B. eine Blattfeder oder eine Drehstabfeder umfassen. Der Wandler zum Umwandeln der mechanischen Federleistung in eine elektrische Leistung ist dann entsprechend an den jeweiligen Stoßdämpfertyp anzupassen. So können z.B. anstelle des oben beschriebenen längsbeweglichen Wandlers auch drehbewegliche Wandler eingesetzt werden.

## Patentansprüche

1. Verfahren zum Aufladen wenigstens einer Kraftfahrzeugbatterie (3) während des Betriebs des Kraftfahrzeugs (1), bei dem der Ladestrom für die Kraftfahrzeugbatterie (3) zumindest teilweise durch das Umwandeln einer mechanischen Leistung der Fahrzeugfederung gewonnen wird und die mechanische Leistung eine Federleistung an wenigstens einem Stoßdämpfer (5) des Kraftfahrzeugs (1) ist,
**dadurch gekennzeichnet,**
**dass** eine Steuereinheit (4) zur Regelung des Ladestroms eine Regelung des Dämpfungsverhaltens wenigstens eines Stoßdämpfers (5) ermöglicht, und dass der Stoßdämpfer (5) wenigstens einen Linearmotor umfasst, der als Generator und als Stellmotor betrieben wird.

2. Verfahren nach Anspruch 1,
**dadurch gekennzeichnet,**
**dass** das Umwandeln auf einem induktiven Prinzip oder auf einem Piezo-Prinzip basiert.

3. Verfahren nach Anspruch 2,
**dadurch gekennzeichnet,**
**dass** das Umwandeln sowohl bei einem positiven Federweg als auch bei einem negativen Federweg erfolgt.

4. Ladevorrichtung für wenigstens eine Kraftfahrzeugbatterie (3), welche insbesondere für den Betrieb mit einem Verfahren gemäß einem der vorausgehenden Ansprüche geeignet ist, die wenigstens einen Wandler umfasst, der eine mechanische Leistung an der Fahrzeugfederung zumindest teilweise in eine elektrische Leistung umwandelt und diese als Ladestrom für die Kraftfahrzeugbatterie (3) bereitstellt, wobei der Wandler in einem Stoßdämpfer (5) der Fahrzeugfederung integriert ist,
**dadurch gekennzeichnet,**
**dass** sie eine Steuereinheit (4) zur Regelung des Ladestroms umfasst, die eine Regelung des Dämpfungsverhaltens wenigstens eines Stoßdämpfers (5) ermöglicht, und dass der Stoßdämpfer (5) wenigstens einen Linearmotor umfasst, der als Generator und als Stellmotor betreibbar ist.

5. Ladevorrichtung nach Anspruch 4,
**dadurch gekennzeichnet,**
**dass** die aufzuladende Kraftfahrzeugbatterie (3) eine Lithium-lonen-Batterie ist.

6. Kraftfahrzeug (1) umfassend eine Ladevorrichtung gemäß einem der Ansprüche 4 bis 5.

7. Kraftfahrzeug (1) nach Anspruch 6,
**dadurch gekennzeichnet,**
**dass** dieses einen Elektroantrieb oder einen Hybridantrieb umfasst, der zumindest teilweise von der aufzuladenden Kraftfahrzeugbatterie (3) mit Energie versorgt wird.

## Claims

1. A method for charging at least one motor vehicle battery (3) during the operation of the motor vehicle (1) in which the charging current for the motor vehicle battery (3) is at least partially obtained by converting mechanical power on the vehicle suspension and the mechanical power is a spring power on at least one shock absorber (5) of the motor vehicle (1),
**characterized in that**
a control unit (4) for controlling the charging current enables the damping behavior of at least one shock absorber (5) to be regulated, and that the shock absorber (5) comprises at least one linear motor operated as a generator and as a servomotor.

2. The method according to claim 1,
**characterized in that**
the conversion is based on an inductive principle or on a piezo principle.

3. The method according to claim 2,
**characterized in that**
the conversion occurs both with a positive spring deflection as well as with a negative spring deflection.

4. A charging apparatus for at least one motor vehicle battery (3) particularly suited to be operated by the method according to any one of the preceding claims which comprises at least one converter which at least partially converts mechanical power on the vehicle suspension into electrical power and provides same as charging current for the motor vehicle battery (3), wherein the converter is integrated into a shock absorber (5) of the vehicle suspension,
**characterized in that**
said charging apparatus comprises a control unit (4) for controlling the charging current which enables the damping behavior of at least one shock absorber (5) to be regulated, and that the shock absorber (5) comprises at least one linear motor able to be operated as a generator and as a servomotor.

5. The charging apparatus according to claim 4,
**characterized in that**
the motor vehicle battery (3) to be charged is a lithium ion battery.

6. A motor vehicle (1) comprising a charging apparatus according to any one of claims 4 to 5.

7. The motor vehicle according to claim 6,
**characterized in that**
same comprises an electric drive or a hybrid drive which is at least partially supplied with energy by the motor vehicle battery (3) to be charged.

## Revendications

1. Procédé servant à charger au moins une batterie de véhicule automobile (3) au cours du fonctionnement du véhicule automobile (1), dans le cadre duquel le courant de charge destiné à la batterie de véhicule automobile (3) est obtenu au moins en partie par la conversion d'une puissance mécanique de la suspension de véhicule et la puissance mécanique est une puissance élastique au niveau au moins d'un amortisseur de chocs (5) du véhicule automobile (1),
**caractérisé en ce**
**qu'**une unité de commande (4) servant à réguler le courant de charge permet une régulation du comportement d'amortissement d'au moins un amortisseur de chocs (5), et en ce que l'amortisseur de chocs (5) comprend au moins un moteur linéaire fonctionnant comme un générateur ou comme un servomoteur.

2. Procédé selon la revendication 1,
**caractérisé en ce**
**que** la conversion repose sur un principe inductif ou sur un principe piézoélectrique.

3. Procédé selon la revendication 2,
**caractérisé en ce**
**que** la conversion est effectuée aussi bien dans le cas d'un trajet élastique positif que dans le cas d'un trajet élastique négatif.

4. Dispositif de charge destiné au moins à une batterie de véhicule automobile (3), qui est adapté en particulier pour le fonctionnement avec un procédé selon l'une quelconque des revendications précédentes, lequel dispositif de charge comprend au moins un convertisseur qui convertit une puissance mécanique au niveau de la suspension de véhicule au moins en partie en une puissance électrique et fournit cette dernière sous la forme d'un courant de charge destiné à la batterie de véhicule automobile (3), sachant que le convertisseur est intégré dans un amortisseur de chocs (5) de la suspension de véhicule,
**caractérisé en ce**
**que** ledit dispositif de charge comprend une unité de commande (4) servant à réguler le courant de charge, laquelle permet une régulation du comportement d'amortissement d'au moins un amortisseur de chocs (5), et en ce que l'amortisseur de chocs (5) comprend au moins un moteur linéaire qui peut fonctionner comme un générateur ou comme un servomoteur.

5. Dispositif de charge selon la revendication 4,
**caractérisé en ce**
**que** la batterie de véhicule automobile (3) à charger est une batterie lithium-ion.

6. Véhicule automobile (1) comprenant un dispositif de charge selon l'une quelconque des revendications 4 à 5.

7. Véhicule automobile (1) selon la revendication 6,
**caractérisé en ce**
**que** ledit véhicule automobile comprend un entraînement électrique ou un entraînement hybride, qui est alimenté en énergie au moins en partie par la batterie de véhicule automobile (3) à charger.
